# EUROPEAN PATENT APPLICATION

(11) **EP 4 745 716 A1**
(43) Date of publication of application: **20.05.2026**
(21) Application number: 25212758.4
(22) Date of filing: 31.10.2025
(51) Int. Cl.: G06F 1/20, G06F 11/30, H05K 7/20

(54) **IDENTIFYING AND REMEDIATING OVERHEATING DEVICES**

(30) Priority: 08.11.2024 IN 202441086013; 29.09.2025 US 202519343375
(71) Applicant: Juniper Networks, Inc., Sunnyvale, CA 94089-1206 (US)
(72) Inventor: SUNKADA, Ganesh, Sunnyvale, 94089 (US); SRIDHAR, Thayumanavan, Sunnyvale, 94089 (US); KOMMULA, Raja, Sunnyvale, 94089 (US); YAVATKAR, Rajendra Shivaram, Sunnyvale, 94089 (US)
(74) Representative: D Young & Co LLP

(57) **Abstract**

This disclosure describes techniques for intelligently detecting overheating devices in a network or data center and taking actions to address such overheating devices. This disclosure also describes evaluating heat dissipation information associated with components of devices in a network, making predictions about network disruptions based on the evaluation of the heat dissipation information, and taking actions to address, mitigate, or prevent such network disruptions. In one example, this disclosure describes a method that includes collecting, by a computing system, information about thermal metrics for a plurality of network devices; identifying, by the computing system and based on the information about the thermal metrics, a specific network device that changes temperature quickly; and taking action, by the computing system, to address effects of overheating associated with the specific network device.

## Description

This application claims the benefit of U.S. Patent Application No. 19/343,375, filed September 29, 2025, which claims the benefit of IN Provisional Patent Application No. 202441086013, filed on November 7, 2024, the entire content of each application is incorporated herein by reference.

### TECHNICAL FIELD

This disclosure relates to computer networks and, more specifically, to managing heat generated in a data center.

### BACKGROUND

Excessive heat can have significant detrimental effects on data centers. Elevated temperatures can lead to hardware failures, resulting in system outages and potential data loss. Additionally, high temperatures can compromise the performance of servers, causing slowdowns that affect the overall efficiency of the data center. Prolonged exposure to heat can accelerate the degradation of electronic components, leading to increased maintenance costs and the need for more frequent replacements. In general, inadequate thermal management poses serious risks to the reliability and operational continuity of data centers.

### SUMMARY

Particular aspects are set out in the appended independent claims. Various optional embodiments are set out in the dependent claims. This disclosure describes techniques for intelligently detecting overheating devices in a network or data center and taking actions to address such overheating devices. This disclosure also describes evaluating heat dissipation information associated with components of devices in a network, making predictions about network disruptions based on the evaluation of the heat dissipation information, and taking actions to address, mitigate, or prevent such network disruptions.

In some examples, this disclosure describes operations performed by a computing system in accordance with one or more aspects of this disclosure. In one specific example, this disclosure describes a method comprising: collecting, by a computing system, information about thermal metrics for a plurality of network devices; identifying, by the computing system and based on the information about the thermal metrics, a specific network device that changes temperature quickly; and taking action, by the computing system, to address effects of overheating associated with the specific network device.

In another example, this disclosure describes a method comprising: collecting, by a computing system, information about heat dissipation associated with each of a plurality of network devices, wherein each of the network devices includes a plurality of components, and wherein collecting the information about heat dissipation includes collecting, for each of the network devices, information about heat dissipation across the plurality of components included within each network device; assessing, by the computing system and based on the information about heat dissipation, cooling efficiency of at least some of the components of the plurality of network devices; and identifying, by the computing system and based on the assessment, a specific network device having a component with an increased risk of failure.

In another example, this disclosure describes a system comprising a storage system and processing circuitry having access to the storage system, wherein the processing circuitry is configured to carry out operations described herein. In yet another example, this disclosure describes a computer-readable storage medium comprising instructions that, when executed, configure processing circuitry of a computing system to carry out operations described herein.

This Summary is intended to provide a brief overview of some of the subject matter described in this document. Accordingly, the above-described features are merely examples and should not be construed to narrow the scope or spirit of the subject matter described herein. Other features, objects, and advantages of the disclosure will be apparent from the description and drawings, and from the claims.

### BRIEF DESCRIPTION OF DRAWINGS

FIG. 1 is a block diagram illustrating an example system including a data center in which examples of the techniques described herein may be implemented.
FIG. 2A, FIG. 2B, and FIG. 2C are conceptual diagrams of an arrangement of devices within racks in a data center, in accordance with one or more aspects of the present disclosure.
FIG. 3A and FIG. 3B are conceptual diagrams of devices within a rack in a data center, where heat dissipation information is collected from the devices, in accordance with one or more aspects of the present disclosure.
FIG. 4 is a flow diagram illustrating operations performed by an example controller in accordance with one or more aspects of the present disclosure.
FIG. 5 is a flow diagram illustrating operations performed by an example computing system in accordance with one or more aspects of the present disclosure.

### DETAILED DESCRIPTION

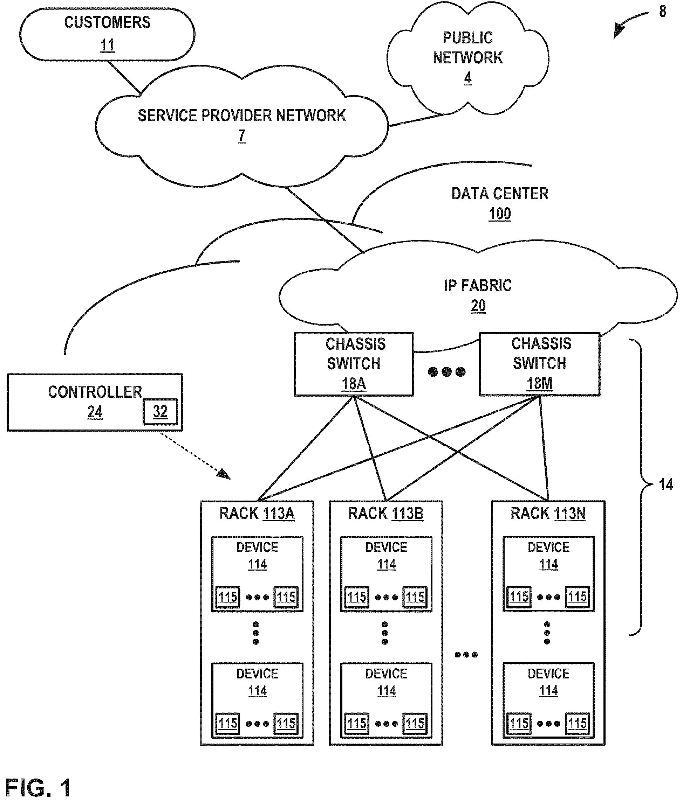

FIG. 1 is a block diagram illustrating an example system 8 including a data center in which examples of the techniques described herein may be implemented. In general, data center 100 provides an operating environment for applications and services for one or more customer sites 11 (illustrated as "customers 11") having one or more customer networks coupled to the data center by service provider network 7. Data center 100 may, for example, host infrastructure equipment, such as networking and storage systems, redundant power supplies, and environmental controls. Service provider network 7 is coupled to public network 4, which may represent one or more networks administered by other providers, and may thus form part of a large-scale public network infrastructure, e.g., the Internet. Public network 4 may represent, for instance, a local area network (LAN), a wide area network (WAN), the Internet, a virtual LAN (VLAN), an enterprise LAN, a layer 3 virtual private network (VPN), an Internet Protocol (IP) intranet operated by the service provider that operates service provider network 7, an enterprise IP network, or some combination thereof.

Although customer sites 11 and public network 4 are illustrated and described primarily as edge networks of service provider network 7, in some examples, one or more of customer sites 11 and public network 4 may be tenant networks within data center 100 or another data center. For example, data center 100 may host multiple tenants (customers) each associated with one or more virtual private networks (VPNs), each of which may implement one of customer sites 11.

Service provider network 7 may offer packet-based connectivity to attached customer sites 11, data center 100, and public network 4. Service provider network 7 may represent a network that is owned and operated by a service provider to interconnect a plurality of networks. In some instances, service provider network 7 represents a plurality of interconnected autonomous systems, such as the Internet, that offers services from one or more service providers.

In some examples, data center 100 may represent one of many geographically distributed network data centers. As illustrated in the example of FIG. 1, data center 100 may be a facility that provides network services for customers. A customer of the service provider may be a collective entity such as enterprises and governments or individuals. For example, a network data center may host web services for several enterprises and end users. Other example services may include data storage, virtual private networks, traffic engineering, file service, data mining, scientific- or super- computing, and so on. Although illustrated as a separate edge network of service provider network 7, elements of data center 100 such as one or more physical network functions (PNFs) or virtualized network functions (VNFs) may be included within the service provider network 7 core.

In the example illustrated in FIG. 1, data center 100 includes devices 114 arranged or housed within racks 113A through 113N ("racks 113"). Each of racks 113 may be coupled to switches 18A through 18M ("chassis switches 18"). Devices 114 may be storage or compute servers, network devices, or other devices. Where devices 114 are servers, such devices may also be referred to herein as "hosts" or "host devices." Each of devices 114 may include one or more components 115.

Switch fabric 14 in the illustrated example includes one or more racks 113 coupled to a distribution layer of chassis (or "spine" or "core") routers or switches 18A-18M (collectively, "chassis switches 18"). Each of racks 113 may include a top of rack switch coupled to the chassis switches 18. In some examples, such a top of rack switch may be one of devices 114. Also, data center 100 may include one or more non-edge switches, routers, hubs, gateways, security devices such as firewalls, intrusion detection, and/or intrusion prevention devices, servers, computer terminals, laptops, printers, databases, wireless mobile devices such as cellular phones or personal digital assistants, wireless access points, bridges, cable modems, application accelerators, or other network devices. Techniques described herein may apply to any of these systems or devices.

In the example illustrated in FIG. 1, chassis switches 18 provide devices 114 with redundant (multi-homed) connectivity to IP fabric 20 and service provider network 7. Chassis switches 18 aggregate traffic flows and provides connectivity between racks 113. Switches within network fabric 14 may be network devices that provide layer 2 (MAC) and/or layer 3 (e.g., IP) routing and/or switching functionality. Top of rack switches and/or chassis switches 18 may each include one or more processors and a memory and can execute one or more software processes. Chassis switches 18 are coupled to IP fabric 20, which may perform layer 3 routing to route network traffic between data center 100 and customer sites 11 by service provider network 7. The switching architecture of data center 100 is merely an example. Other switching architectures may have more or fewer switching layers, for instance.

Although devices 114 may represent networking equipment, such as switches or routers, one or more of devices 114 could be a compute node, an application server, a storage server, or other type of server. For example, one or more of devices 114 may represent a computing device, such as an x86 processor-based server, configured to operate according to techniques described herein. In some examples, devices 114 may provide Network Function Virtualization Infrastructure (NFVI) for an NFV architecture. Devices 114 may host endpoints for one or more virtual networks that operate over the physical network represented here by IP fabric 20 and switch fabric 14. Although described primarily with respect to a data center-based switching network, other physical networks, such as service provider network 7, may underlay the one or more virtual networks.

Controller 24 provides a logically and in some cases physically centralized system for facilitating operation of one or more virtual networks within data center 100. Controller 24 may manage other aspects of data center 100, which may include managing one or more networks and networking services such as load balancing, and security. Controller 24 may allocate resources from devices 114 that serve as host devices to various applications. Controller 24 may implement high-level requests from an orchestration engine (not specifically shown) configuring physical switches, top-of-rack switches, chassis switches, switch fabric 14; physical routers; physical service nodes such as firewalls and load balancers; and virtual services such as virtual firewalls in a VM. Controller 24 maintains routing, networking, and configuration information within a state database.

Heat management module 32, which may be included within controller 24, may perform functions relating to managing heat attributes of devices 114 and/or components 115. In some examples, heat management module 32 may perform intelligent detection of devices 114 that are overheating. Alternatively, or in addition, heat management module 32 may evaluate information about heat dissipation properties of devices 114 and/or components 115 and predict network disruptions that may occur as a result the heat dissipation properties of such devices 114 or components 115. Heat management module may also take one or more actions in response to detecting devices that are overheating, or in response to predicted network disruptions. Although heat management module 32 is illustrated in FIG. 1 as being a part of controller 24, in other examples, heat management module 32 may be implemented separately, or as part of another system, device, or module within system 8. For instance, some or all of heat management module 32 may be implemented as part of a rack controller, included within one or more racks 113. Alternatively, or in addition, some or all of heat management module 32 may be implemented as part of a device or chassis controller, included within one or more devices 114.

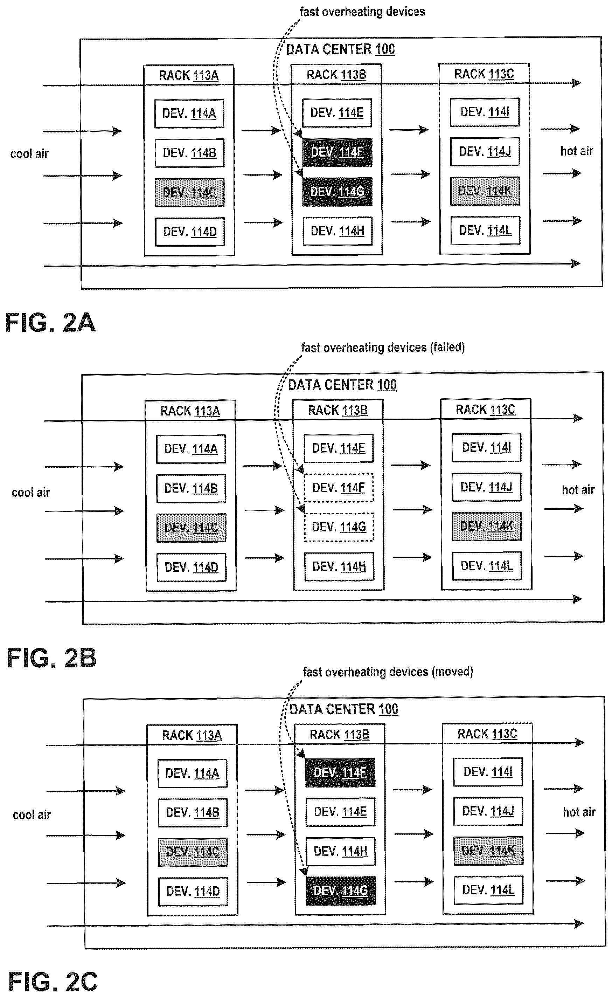

FIG. 2A, FIG. 2B, and FIG. 2C are conceptual diagrams of an arrangement of devices within racks in a data center, in accordance with one or more aspects of the present disclosure. Each of FIG. 2A, 2B, and 2C includes some of the same elements of system 8 of FIG. 1, including data center 100, which may correspond to data center 100 of FIG. 1. FIG. 2A, 2B, and 2C also illustrate racks 113A through 113C, which may be a selection of the racks 113A through 113N illustrated in FIG. 1.

As in FIG. 1, each of racks 113 in FIG. 2A, 2B, and 2C include a number of network devices or devices 114. Specifically, rack 113A includes devices 114A, 114B, 114C, and 114D. Rack 113B includes devices 114E, 114F, 114G, and 114H, and rack 113C includes devices 114I, 114J, 114K, and 114L. For ease of illustration, only a limited number of racks 113 and devices 114 are illustrated in FIGS. 2A, 2B, and 2C, but techniques described herein may apply in situations involving any number of racks or devices.

In the example described, devices 114 may consist of network switches distributed by different vendors having different thermal characteristics. In data center networks, the network devices will often be arranged in racks one above the other, as depicted in FIG. 2A, 2B, and 2C. When setting up a network, an administrator typically arranges devices 114 based on cabling and connectivity requirements. However, this arrangement can sometimes result in uneven airflow distribution, causing some devices to receive insufficient cooling. This can lead to overheating and, eventually, component or device failure or shutdown. As shown in FIG. 2A, devices 114F and 114G are overheating more quickly than others due to their thermal characteristics and inadequate exposure to cold air. This propensity to overheat more quickly than others is indicated by the dark shading applied to devices 114F and 114G in FIG. 2A. As illustrated in FIG. 2A, devices 114C and 114K may also show signs of overheating quickly, but less so than devices 114F and 114G (as is indicated in FIG. 2A with less dark shading applied to devices 114C and 114K).

As indicated by the dotted lines depicting devices 114F and 114G in FIG. 2B, devices 114F and 114G have an increased risk of failure, and may eventually shut down or fail due to overheating effects associated with one or more components of such devices. If these failures are unexpected, due to a lack of knowledge about overheating or failure to predict or analyze the thermal characteristics of devices 114 under different temperature conditions, these failures may lead to network disruptions within data center 100.

In accordance with one or more aspects of the present disclosure, heat management module 32 of controller 24 (see FIG. 1) may perform analytical techniques to identify devices 114 that heat up or cool down quickly based on their thermal metrics. In some examples, but not necessarily all, this capability could be integrated into the network controller 24 that manages data center 100 or the data center's network devices. Heat management module 32 periodically gathers temperature data from various sensors within each device 114, primarily from sensors placed at key locations on the device chassis of each network device (e.g., at air inlets and outlets). These metrics provide insight into the thermal behavior of the devices.

Heat management module 32 may store the collected data in a time-series data store or database, allowing for periodic analysis of temperature metrics. Using this data, heat management module 32 calculates analytical metrics such as the rate of heating and rate of cooling. The rate of heating measures the increase in a device's temperature per unit of time, while the rate of cooling tracks the temperature decrease over the same period.

By analyzing these metrics, heat management module 32 identifies devices 114 that overheat or cool down rapidly within each data center rack 113. Once overheating or cooling devices are detected, heat management module 32 may take action to address potential issues, which may include generating and sending an alert providing information about overheating associated devices or recommending possible rearrangements of devices 114 within a rack 113 to a network administrator. For instance, overheating devices can be relocated to areas with better cold air circulation. As illustrated in FIG. 2C, devices 114F and 114G, which were overheating quickly in FIG. 2A, have been physically moved to the top and bottom of rack 113B to expose them to increased airflow. In some cases, heat management module 32 may logically move devices 114F and 114G to the top and bottom of the rack (e.g., by rearranging workloads).

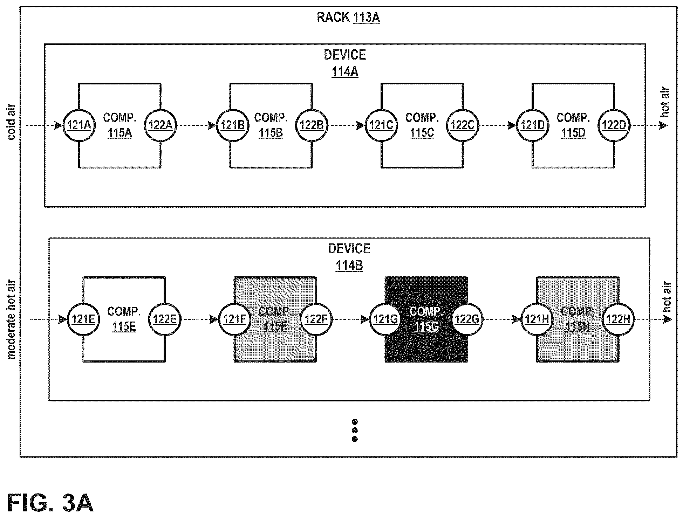

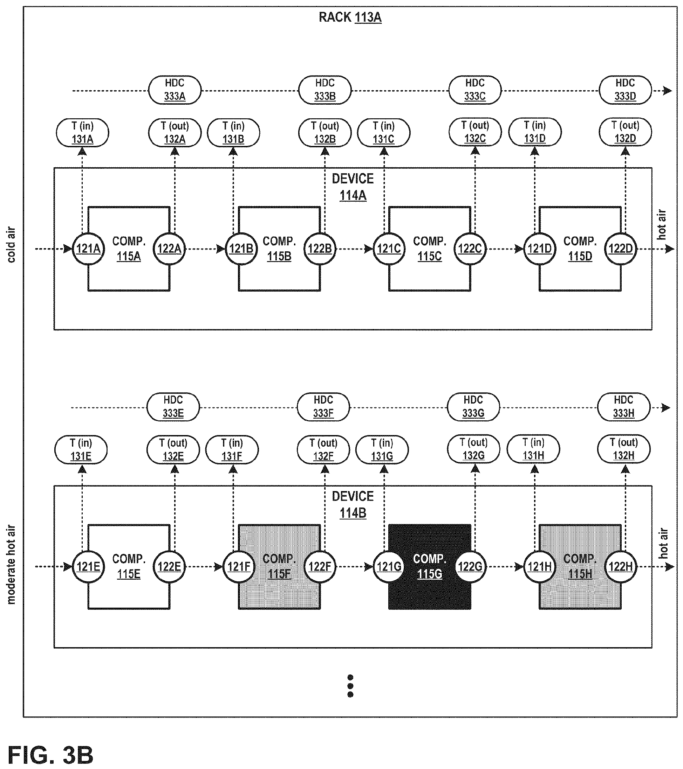

FIG. 3A and FIG. 3B are conceptual diagrams of devices within a rack in a data center, where heat dissipation information is collected from the devices, in accordance with one or more aspects of the present disclosure. Devices 114A and 114B, shown in both FIG. 3A and FIG. 3B, may correspond to devices 114A and 114B from rack 113A illustrated in each of FIG. 2A, 2B, and 2C.

Device 114A in FIG. 3A and FIG. 3B includes one or more components 115A through 115D ("components 115"), and device 114B includes components 115E through 115H ("components 115"). Components 115 are intended to represent components included within a device, and may generally correspond to components such as the processors or logic circuits that compose a switch, router, compute node, or other device. For ease of illustration, only a limited number of devices 114 and components 115 are illustrated in FIGS. 3A and 3B, but techniques described herein may apply in situations involving any number of devices or components.

Each of components 115 may have one or more sensors. In FIG. 3A and FIG. 3B, each of components 115 has an inlet sensor 121 and an outlet sensor 122. For example, in FIG. 3A, component 115A has an inlet sensor 121A and an outlet sensor 122A. Inset sensor 121A determines the temperature at the inlet of component 115A, and outlet sensor 122A determines the temperature at the outlet of the component 115A. Other components 115 shown in FIG. 3A and 3B have correspondingly labeled sensors 121 and 122 and operate similarly.

When there are air ventilation or cooling issues within a rack 113 or associated with a device 114, such as fan failures or obstructions in the ventilation openings of the network device chassis, the components 115 within the chassis can begin to overheat. Although alarms or alerts could be triggered in this situation, notifying an administrator or other system when the temperature sensors in the chassis detect high readings, this approach focuses on individual temperature sensors and may not adequately indicate underlying cooling system problems. Additionally, if alarms are generated only after the chassis components 115 have already overheated, the overheating device 114 may fail or automatically shut down before network administrators have a chance to respond to the alert. This reactive approach has at least two drawbacks: (1) by only monitoring individual temperature sensors, this approach fails to identify underlying cooling system problems such as fan failures or blocked ventilation ports, and (2) the delayed nature of these alerts means components 115 may fail or trigger emergency shutdowns before administrators can respond, as warnings come only after critical overheating has occurred.

FIG. 3A illustrates that components 115F and 115G are vulnerable to overheating when exposed to even moderately warm air entering the chassis associated with device 114B (see shading applied to various components 115 in FIG. 3A), potentially leading to component failure or system shutdown. Without automated preventive monitoring systems, network disruptions can persist until administrators manually investigate and identify the root cause, whether it is ventilation problems, faulty components, or problematic upgrades. This lack of predictive cooling management is particularly critical in large-scale data centers, where thermal issues can result in significant network disruptions.

In accordance with one or more aspects of the present disclosure, heat management module 32 of controller 24 (see FIG. 1) may use heat dissipation patterns to proactively identify network devices 114 at risk of overheating, enabling administrators to address thermal issues before they cause component or device failures. Heat dissipation is an indicator of the amount of heat generated by device components 115 getting dissipated when air flows over the chassis components.

In FIG. 3B, a heat management module (e.g., included within controller 24 of FIG. 1) may continuously monitor heat dissipation across different chassis components 115 using strategically placed temperature sensors (e.g., inset sensors 121 and outlet sensors 122 placed at locations that tend to identify the largest temperature differentials for a given component 115). This measurement indicates how effectively generated heat is being removed by airflow across the components. As illustrated in FIG. 3B, for example, inlet sensor 121A may determine an inlet temperature 131A associated with the inlet of component 115A, and outlet sensor 122A may determine an outlet temperature 132A associated with the outlet of component 115A. Similarly, inlet sensor 121B may determine an inlet temperature 131B associated with the inlet of component 115B, and outlet sensor 122B may determine an outlet temperature 132B associated with the outlet of component 115B. In a similar manner, inlet temperatures 131 and outlet temperatures 132 may be determined for each of components 115C through 115H in FIG. 3B. By tracking these heat dissipation patterns over time, heat management module 32 can assess the cooling efficiency of each component.

In some examples, heat management module 32 stores component heat dissipation metrics in a time-series database. For example, heat management module may determine a heat dissipation at component (HDC) metric 333A for component 115A by computing the difference of the temperature between the inlet temperature 131A and outlet temperature 132A of component 115A. Similar HDC metrics 333 for each of components 115 in FIG. 3B can be calculated using the corresponding inlet temperature 131 and outlet temperature 132 for any given component 115.

Heat management module 32 may use this historical data to train machine learning models. These trained models forecast future heat dissipation patterns for each chassis component. By analyzing these predictions, heat management module 32 (or the network controller 24) can identify components at an increased risk of overheating and potential failure. This proactive approach allows heat management module 32 or network administrators to address thermal issues before they cause network disruptions.

Accordingly, in some examples, heat management module 32 may generate predictions about potential network disruptions based on thermal metrics data or heat dissipation data. In response to such predictions, heat management module may use the predictions to generate control signals that are used to control other systems within the data center 100 (or the system 8 generally, see FIG. 1). Specifically, heat management module 32 may send control signals to one or more systems within data center 100, instructing one or more of such systems to perform a specific operation (e.g., adjust workloads, modify resources allocated to workloads, adjust routing patterns, modify network operations, generate an alert, enable or disable access to resources, physically or logically move devices 114 within a rack 113). Accordingly, heat management module 32 may control the operation of various other systems through predictions made by applying a machine learning model trained to identify heating issues.

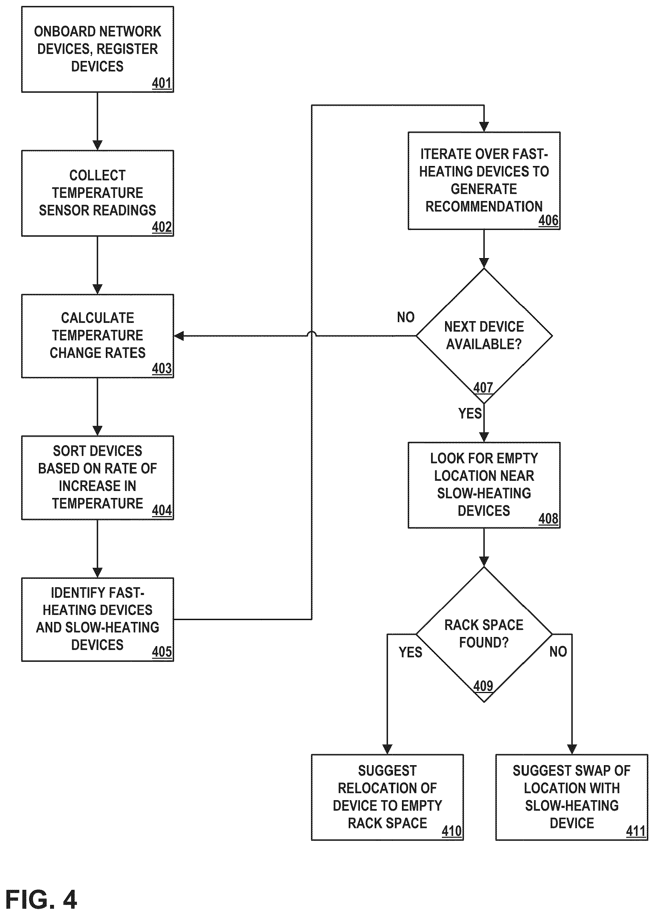

FIG. 4 is a flow diagram illustrating operations performed by an example controller in accordance with one or more aspects of the present disclosure. FIG. 4 is described below within the context of controller 24 of FIG. 1. Operations described in FIG. 4 may, in other examples, be performed by one or more other components, modules, systems, or devices. In other words, although operations are described as being performed by controller 24, such operations may be performed by one or more other devices (e.g., a dedicated system, a chassis controller, a rack controller, or another device or collection of devices). Further, in other examples, operations described in connection with FIG. 4 may be merged, performed in a difference sequence, omitted, or may encompass additional operations not specifically illustrated or described.

In the process illustrated in FIG. 4, and in accordance with one or more aspects of the present disclosure, controller 24 may onboard network devices and register network devices (401). For example, a telemetry data collector module within controller 24 collects information about devices on a network, stores information about the devices, and prepares them for collection of thermal information.

Controller 24 may collect temperature sensor readings (402). For example, the telemetry collector module within controller 24 collects, over time, temperature sensor readings from one or more locations on the device chassis for each of the registered devices on the network. The telemetry collector module may collect such readings on a continual, periodic, or occasional basis.

Controller 24 may calculate temperature change rates (403). For example, controller 24 uses the temperature readings to calculate the rate of increasing and decreasing temperature over time for each of the network devices. Controller 24 may perform such calculations for each device in a rack and/or for each device in the network.

Controller 24 may sort the network devices (404). For example, controller 24 may sort the devices (e.g., those onboarded and monitored) based on the calculated rate of temperature increase. Controller 24 may sort the devices based on the aggregated temperatures collected for each device. In the example being described, the devices are sorted so that the devices at the top of the list are increasing in temperature more quickly than those devices at the bottom of the list.

Controller 24 may identify fast-heating devices and slow-heating devices (405). For example, controller 24 identifies devices at the top of the sorted list as "fast-heating" devices and identifies devices at the bottom of the list as "slow-heating" devices.

Controller 24 may iterate over the fast-heating devices to generate a recommendation (406). For example, controller 24 may address (as described herein) each fast-heating device until there are no other fast-heating devices in the list (NO path from 407). But for each such device in the list (YES path from 407), controller 24 looks for an empty location near one or more slow-heating devices (408). Such a location may be within the same rack, another rack, or elsewhere. If an empty rack spot is found, controller 24 recommends relocation of the fast-heating device being addressed to the empty rack spot (YES path from 409 and 410). If an empty rack spot is not found, controller 24 may recommend swapping the fast-heating device with another device that might be considered a slow-heating device (NO path from 409 and 411).

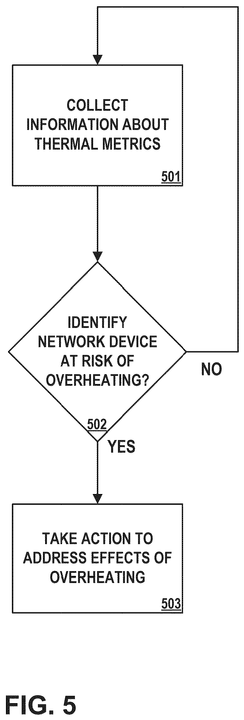

FIG. 5 is a flow diagram illustrating operations performed by an example computing system in accordance with one or more aspects of the present disclosure. FIG. 5 is described below within the context of heat management module 32 executing within controller 24 of FIG. 1 and the example illustrated in FIG. 3B. Operations described in FIG. 5 may, in other examples, be performed by one or more other components, modules, systems, or devices. Specifically, although operations are described as being performed by heat management module 32 executing at controller 24, in other examples, heat management module 32 may be executing on one or more other devices (e.g., a dedicated system, a chassis controller, a rack controller, or another device or collection of devices). Further, in other examples, operations described in connection with FIG. 5 may be merged, performed in a difference sequence, omitted, or may encompass additional operations not specifically illustrated or described.

In the process illustrated in FIG. 5, and in accordance with one or more aspects of the present disclosure, controller 24 may collect information about thermal metrics (501). For example, in FIG. 1, heat management module 32 of controller 24 collects information about temperatures detected across components 115 of devices 114. As shown in FIG. 3B, inlet sensors 121 and outlet sensors 122 detect inlet temperatures 131 and outlet temperatures 132, respectively, across components 115A, 115B, 115C, and 115D of device 114A and across components 115E, 115F, 115G, and 115H of device 114B. Using these temperatures, heat management module 32 calculates, for components 115 within devices 114A and 114B, the heat dissipation value for that component.

For example, for device 114A of FIG. 3B, heat management module 32 calculates HDC 333A (i.e., heat dissipation at component 115A), HDC 333B for component 115B, HDC 333C for component 115C, and HDC 333D for component 115D. Similarly, for device 114B, heat management module 32 calculates HDC 333E (i.e., heat dissipation at component 115E), HDC 333F for component 115F, HDC 333G for component 115G, and HDC 333H for component 115H. Heat management module 32 collects temperatures 131 over time, enabling calculation of a time series of heat dissipation values 133. Heat management module 32 stores the series of temperatures 131 and/or the series of HDC 333 calculations in a data store (e.g., within controller 24 or elsewhere).

Controller 24 may identify a network device at risk of overheating (502). For example, in FIG. 1, heat management module 32 analyzes the series of heat dissipation values stored in the data store and uses the information to identify a device 114 that has one or more components that show signs of poor heat dissipation. In some examples, poor heat dissipation may be inferred for components that are changing (e.g., increasing) temperature quickly. To perform the analysis of the series of heat dissipation values, heat management module 32 may apply a machine learning model that has been trained to identify poor heat dissipation for device components based on a series of inlet and outlet temperatures. In an example that can be described in the context of FIG. 3B, heat management module 32 of controller 24 (see FIG. 1) applies a machine learning model, which forecasts future heat dissipation patterns indicating that component 115G will overheat or at least is at an increased risk of overheating and potential failure. Heat management module 32 therefore identifies network device 114B as being at risk of overheating and potential failure.

Controller 24 may take action to address the effects of overheating (503). For example, heat management module 32 of controller 24 (see FIG. 1) determines that, given the forecasted heat dissipation patterns, a proactive approach to addressing the risk that device 114B overheats and fails should be taken for network device 114B in FIG. 3B. In some examples, the machine learning model not only forecasts poor heat dissipation for devices, but the model may also recommend actions to take to proactively address the risk of overheating and failure.

In one example, the machine learning model recommends that workloads executing on device 114B be offloaded to another device not at risk of overheating and failure. In such an example, heat management module 32 identifies workloads running at device 114B. Heat management module 32 reallocates one or more of those workloads to a different device 114, such as device 114A in FIG. 3B. When identifying workloads, heat management module 32 may attempt to identify (e.g., by applying a machine learning model) which of the workloads executing on device 114B is causing poor heat dissipation for component 115G (i.e., those workloads potentially contributing most to the risk of overheating of device 114B). Heat management module 32 uses this analysis to identify which of the workloads executing on device 114B should be offloaded to device 114A, and heat management module 32 may prioritize moving those workload(s) that seem to be contributing most to the poor heat dissipation. Heat management module 32 causes controller 24 to output control signals to devices 114B and 114A, causing reallocation of workloads from device 114B to device 114A. After offloading workloads from device 114B to device 114A, device 114B may be at reduced risk of overheating.

In another example, the machine learning model may recommend physical changes, such as changes to air circulation patterns so that device 114B experiences better airflow. In such an example, each device 114 may be physically located in an enclosure or environment (e.g., rack 113 or other enclosure, data center, or building) that may have systems available that are capable of physically changing the cooling attributes of the environment for at least some of devices 114, and where those systems can be controlled or adjusted by controller 24. Such systems may involve cooling systems (e.g., fans, airflow adjusting systems, liquid cooling systems, and/or other temperature regulating systems) or robotic or mechanical movement systems that may be able to physically move the location of various racks 113 or devices 114 within racks 113 to adjust air flow attributes experienced by devices 114. In such an example, heat management module 32 causes controller 24 to output a series of control signals to control or modify the operation of one or more of such systems, such as a cooling system that affects device 114B. In response to receiving such control signals, the cooling system interprets the control signals and modifies its operation accordingly, which may result in a cooler environment for device 114B. Accordingly, in any of a number of ways, heat management module 32 of controller 24 may use thermal metrics and/or predictions generated by a model to control the operation of other systems. Specifically, controller 24 may control temperature regulating systems or other systems available within rack 113, data center 100, or otherwise to proactively address risks of overheating and failure.

Thus, from one perspective, there have now been described techniques for intelligently detecting overheating devices in a network or data center and taking actions to address such overheating devices. This disclosure also describes evaluating heat dissipation information associated with components of devices in a network, making predictions about network disruptions based on the evaluation of the heat dissipation information, and taking actions to address, mitigate, or prevent such network disruptions. In one example, this disclosure describes a method that includes collecting, by a computing system, information about thermal metrics for a plurality of network devices; identifying, by the computing system and based on the information about the thermal metrics, a specific network device that changes temperature quickly; and taking action, by the computing system, to address effects of overheating associated with the specific network device.

For processes, apparatuses, and other examples or illustrations described herein, including in any flowcharts or flow diagrams, certain operations, acts, steps, or events included in any of the techniques described herein can be performed in a different sequence, may be added, merged, or left out altogether (e.g., not all described acts or events are necessary for the practice of the techniques). Moreover, in certain examples, operations, acts, steps, or events may be performed concurrently, e.g., through multi-threaded processing, interrupt processing, or multiple processors, rather than sequentially. Further certain operations, acts, steps, or events may be performed automatically even if not specifically identified as being performed automatically. Also, certain operations, acts, steps, or events described as being performed automatically may be alternatively not performed automatically, but rather, such operations, acts, steps, or events may be, in some examples, performed in response to input or another event.

The disclosures of all publications, patents, and patent applications referred to herein are hereby incorporated by reference. To the extent that any material that is incorporated by reference conflicts with the present disclosure, the present disclosure shall control.

For ease of illustration, only a limited number of devices are shown within the Figures and/or in other illustrations referenced herein. However, techniques in accordance with one or more aspects of the present disclosure may be performed with many more of such systems, components, devices, modules, and/or other items, and collective references to such systems, components, devices, modules, and/or other items may represent any number of such systems, components, devices, modules, and/or other items.

The Figures included herein each illustrate at least one example implementation of an aspect of this disclosure. The scope of this disclosure is not, however, limited to such implementations. Accordingly, other example or alternative implementations of systems, methods or techniques described herein, beyond those illustrated in the Figures, may be appropriate in other instances. Such implementations may include a subset of the devices and/or components included in the Figures and/or may include additional devices and/or components not shown in the Figures.

The detailed description set forth above is intended as a description of various configurations and is not intended to represent the only configurations in which the concepts described herein may be practiced. The detailed description includes specific details for the purpose of providing a sufficient understanding of the various concepts. However, these concepts may be practiced without these specific details. In some instances, well-known structures and components are shown in block diagram form in the referenced figures in order to avoid obscuring such concepts.

Accordingly, although one or more implementations of various systems, devices, and/or components may be described with reference to specific Figures, such systems, devices, and/or components may be implemented in a number of different ways. For instance, one or more devices illustrated herein as separate devices may alternatively be implemented as a single device; one or more components illustrated as separate components may alternatively be implemented as a single component. Also, in some examples, one or more devices illustrated in the Figures herein as a single device may alternatively be implemented as multiple devices; one or more components illustrated as a single component may alternatively be implemented as multiple components. Each of such multiple devices and/or components may be directly coupled via wired or wireless communication and/or remotely coupled via one or more networks. Also, one or more devices or components that may be illustrated in various Figures herein may alternatively be implemented as part of another device or component not shown in such Figures. In this and other ways, some of the functions described herein may be performed via distributed processing by two or more devices or components.

Further, certain operations, techniques, features, and/or functions may be described herein as being performed by specific components, devices, and/or modules. In other examples, such operations, techniques, features, and/or functions may be performed by different components, devices, or modules. Accordingly, some operations, techniques, features, and/or functions that may be described herein as being attributed to one or more components, devices, or modules may, in other examples, be attributed to other components, devices, and/or modules, even if not specifically described herein in such a manner.

Although specific advantages have been identified in connection with descriptions of some examples, various other examples may include some, none, or all of the enumerated advantages. Other advantages, technical or otherwise, may become apparent to one of ordinary skill in the art from the present disclosure. Further, although specific examples have been disclosed herein, aspects of this disclosure may be implemented using any number of techniques, whether currently known or not, and accordingly, the present disclosure is not limited to the examples specifically described and/or illustrated in this disclosure.

In one or more examples, the functions described may be implemented in hardware, software, firmware, or any combination thereof. If implemented in software, the functions may be stored, as one or more instructions or code, on and/or transmitted over a computer-readable medium and executed by a hardware-based processing unit. Computer-readable media may include computer-readable storage media, which corresponds to a tangible medium such as data storage media, or communication media including any medium that facilitates transfer of a computer program from one place to another (e.g., pursuant to a communication protocol). In this manner, computer-readable media generally may correspond to (1) tangible computer-readable storage media, which is non-transitory or (2) a communication medium such as a signal or carrier wave. Data storage media may be any available media that can be accessed by one or more computers or one or more processors to retrieve instructions, code and/or data structures for implementation of the techniques described in this disclosure. A computer program product may include a computer-readable medium.

By way of example, and not limitation, such computer-readable storage media can include RAM, ROM, EEPROM, or optical disk storage, magnetic disk storage, or other magnetic storage devices, flash memory, or any other medium that can be used to store desired program code in the form of instructions or data structures and that can be accessed by a computer. Also, any connection may properly be termed a computer-readable medium. For example, if instructions are transmitted from a website, server, or other remote source using a wired (e.g., coaxial cable, fiber optic cable, twisted pair) or wireless (e.g., infrared, radio, and microwave) connection, then the wired or wireless connection is included in the definition of medium. It should be understood, however, that computer-readable storage media and data storage media do not include connections, carrier waves, signals, or other transient media, but are instead directed to non-transient, tangible storage media.

Instructions may be executed by one or more processors, such as one or more digital signal processors (DSPs), general purpose microprocessors, application specific integrated circuits (ASICs), field programmable logic arrays (FPGAs), or other equivalent integrated or discrete logic circuitry. Accordingly, the terms "processor" or "processing circuitry" as used herein may each refer to any of the foregoing structure or any other structure suitable for implementation of the techniques described. In addition, in some examples, the functionality described may be provided within dedicated hardware and/or software modules. Also, the techniques could be fully implemented in one or more circuits or logic elements.

The techniques of this disclosure may be implemented in a wide variety of devices or apparatuses, including, to the extent appropriate, a wireless handset, a mobile or non-mobile computing device, a wearable or non-wearable computing device, an integrated circuit (IC) or a set of ICs (e.g., a chip set). Various components, modules, or units are described in this disclosure to emphasize functional aspects of devices configured to perform the disclosed techniques, but do not necessarily require realization by different hardware units. Rather, as described above, various units may be combined in a hardware unit or provided by a collection of interoperating hardware units, including one or more processors as described above, in conjunction with suitable software and/or firmware.

Further examples of feature combinations taught by the present disclosure are set out in the following numbered clauses:
1. A computing system comprising processing circuitry and storage media, wherein the processing circuitry has access to the storage media and is configured to:
   collect information about thermal metrics for a plurality of network devices;
   identify, based on the information about thermal metrics, a specific network device that is at risk of overheating; and
   take action to address effects of overheating associated with the specific network device.
2. The computing system of clause 1, wherein to collect information about thermal metrics, the processing circuitry is further configured to:
   collect information about heat dissipation associated with each of the plurality of network devices.
3. The computing system of clause 2, wherein each of the plurality of network devices includes a plurality of components, and wherein to collect information about heat dissipation associated with each of the plurality of network devices, the processing circuitry is further configured to:
   collect, for each of the network devices, information about heat dissipation across the plurality of components included within each network device.
4. The computing system of clause 3, wherein to identify the specific network device, the processing circuitry is further configured to:
   assess, based on the information about heat dissipation, cooling efficiency of at least some of the plurality of components within each network device of the plurality of network devices.
5. The computing system of clause 4, wherein to identify the specific network device, the processing circuitry is further configured to:
   determine, based on the assessment, that the specific network device has a component at risk of failure.
6. The computing system of any preceding clause, wherein to collect information about thermal metrics, the processing circuitry is further configured to:
   collect temperature data from sensors associated with each of the plurality of network devices.
7. The computing system of clause 6, wherein each of the plurality of network devices has a chassis, and wherein to collect temperature data from the sensors, the processing circuitry is further configured to:
   collect temperature data from sensors placed at key locations on the chassis of each of the plurality of network devices.
8. The computing system of any preceding clause, wherein to collect the information about thermal metrics, the processing circuitry is further configured to:
   store the information in a time-series data store; and
   enable periodic time-series analysis, based on the stored information, of temperature metrics for each of the plurality of network devices.
9. The computing system of any preceding clause, wherein to identify a specific network device that is at risk of overheating, the processing circuitry is further configured to:
   identify a specific network device that overheats quickly.
10. The computing system of any preceding clause, wherein to take action to address the effects of overheating associated with the specific network device, the processing circuitry is further configured to:
   generate an alert providing information about overheating associated with the specific network device; and
   enable an administrator to take action.
11. The computing system of clause 10, wherein to generate the alert providing information, the processing circuitry is further configured to:
   include information recommending a rearrangement in which the specific network device is relocated to a location with better air circulation.
12. The computing system of any preceding clause, wherein to take action to address the effects of overheating associated with the specific network device, the processing circuitry is further configured to:
   reallocate a workload by removing the workload from the specific network device.
13. The computing system of any of clauses 2 to 12 when dependent on clause 2, wherein to collect the information about heat dissipation associated with each of the plurality of network devices, the processing circuitry is further configured to:
   store time series data associated with heat dissipation metrics.
14. The computing system of clause 13, wherein to identify the specific network device that shows signs of overheating, the processing circuitry is further configured to:
   train a machine learning model, based on at least some of the time series data, to predict heat dissipation patterns for components within network devices;
   apply the machine learning model to predict that the specific network device has a component at risk of failure.
15. The computing system of any preceding clause, wherein to take action to address the effects of overheating associated with the specific network device, the processing circuitry is further configured to:
   send control signals to another system, instructing the other system to perform an operation to address the effects of overheating associated with the specific network device.
16. A method comprising:
   collecting, by a computing system, information about thermal metrics for a plurality of network devices;
   identifying, by the computing system and based on the information about thermal metrics, a specific network device that is at risk of overheating; and
   taking action, by the computing system, to address effects of overheating associated with the specific network device.
17. The method of clause 16, wherein collecting information about thermal metrics includes:
   collecting information about heat dissipation associated with each of the plurality of network devices.
18. The method of clause 17, wherein each of the plurality of network devices includes a plurality of components, and wherein collecting information about heat dissipation associated with each of the plurality of network devices includes:
   collecting, for each of the network devices, information about heat dissipation across the plurality of components included within each network device.
19. The method of clause 18, wherein identifying the specific network device includes:
   assessing, based on the information about heat dissipation, cooling efficiency of at least some of the components of the plurality of network devices.
20. Computer-readable media encoding instructions that, when executed, cause processing circuitry of a computing system to:
   collect information about thermal metrics for a plurality of network devices;
   identify, based on the information about thermal metrics, a specific network device that is at risk of overheating; and
   take action to address effects of overheating associated with the specific network device.

## Claims

1. A computing system comprising processing circuitry and storage media, wherein the processing circuitry has access to the storage media and is configured to:
collect information about thermal metrics for a plurality of network devices;
identify, based on the information about thermal metrics, a specific network device that is at risk of overheating; and
take action to address effects of overheating associated with the specific network device.

2. The computing system of claim 1, wherein to collect information about thermal metrics, the processing circuitry is further configured to:
collect information about heat dissipation associated with each of the plurality of network devices.

3. The computing system of claim 2, wherein each of the plurality of network devices includes a plurality of components, and wherein to collect information about heat dissipation associated with each of the plurality of network devices, the processing circuitry is further configured to:
collect, for each of the network devices, information about heat dissipation across the plurality of components included within each network device.

4. The computing system of claim 3, wherein to identify the specific network device, the processing circuitry is further configured to:
assess, based on the information about heat dissipation, cooling efficiency of at least some of the plurality of components within each network device of the plurality of network devices.

5. The computing system of claim 4, wherein to identify the specific network device, the processing circuitry is further configured to:
determine, based on the assessment, that the specific network device has a component at risk of failure.

6. The computing system of any of claims 1-5, wherein to collect information about thermal metrics, the processing circuitry is further configured to:
collect temperature data from sensors associated with each of the plurality of network devices.

7. The computing system of claim 6, wherein each of the plurality of network devices has a chassis, and wherein to collect temperature data from the sensors, the processing circuitry is further configured to:
collect temperature data from sensors placed at key locations on the chassis of each of the plurality of network devices.

8. The computing system of any of claims 1-5, wherein to collect the information about thermal metrics, the processing circuitry is further configured to:
store the information in a time-series data store; and
enable periodic time-series analysis, based on the stored information, of temperature metrics for each of the plurality of network devices.

9. The computing system of any of claims 1-5, wherein to identify a specific network device that is at risk of overheating, the processing circuitry is further configured to:
identify a specific network device that overheats quickly.

10. The computing system of any of claims 1-5, wherein to take action to address the effects of overheating associated with the specific network device, the processing circuitry is further configured to:
generate an alert providing information about overheating associated with the specific network device; and
enable an administrator to take action.

11. The computing system of claim 10, wherein to generate the alert providing information, the processing circuitry is further configured to:
include information recommending a rearrangement in which the specific network device is relocated to a location with better air circulation.

12. The computing system of any of claims 1-5, wherein to take action to address the effects of overheating associated with the specific network device, the processing circuitry is further configured to:
reallocate a workload by removing the workload from the specific network device.

13. A method comprising:
collecting, by a computing system, information about thermal metrics for a plurality of network devices;
identifying, by the computing system and based on the information about thermal metrics, a specific network device that is at risk of overheating; and
taking action, by the computing system, to address effects of overheating associated with the specific network device.

14. The method of claim 13, further comprising steps corresponding to the functionality recited in any of claims 2-12.

15. A computer-readable medium comprising instructions that, when executed by one or more programmable processors, cause the one or more programmable processors to perform the method recited by any of claims 13-14.
